**Europäisches Patentamt**

(19) **European Patent Office**

**Office européen des brevets**

(11) Publication number: **0 028 354**

**A1**

(12) # EUROPEAN PATENT APPLICATION

(21) Application number: **80106417.1**

(22) Date of filing: **21.10.80**

(51) Int. Cl.³: **H 01 L 27/02**
**H 03 K 19/091**

(30) Priority: **05.11.79 US 91671**

(43) Date of publication of application:
**13.05.81 Bulletin 81 19**

(84) Designated Contracting States:
**DE FR GB**

(71) Applicant: **TEXAS INSTRUMENTS INCORPORATED**
**13500 North Central Expressway**
**Dallas Texas 75265(US)**

(72) Inventor: **Hewlett, Frank W., Jr.**
**5924 Marquita**
**Dallas Texas 75206(US)**

(74) Representative: **Leiser, Gottfried, Dipl.-Ing. et al,**
**Patentanwälte Prinz-Hauser-Leiser Ernsberger Strasse**
**19**
**D-8000 München 60(DE)**

(54) **Vertical Schottky logic.**

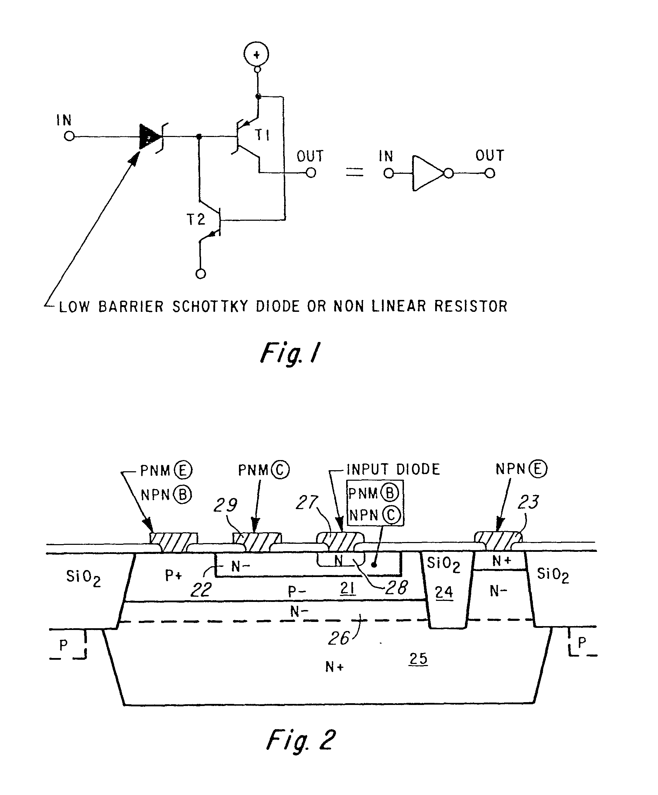

(57) A Schottky collector transistor (PNM) inverter circuit is used to implement a positive logic, multiple input, single output NAND gate or a single input, multiple output NOR gate. The NAND function is achieved by merging two PNM inverters in a common emitter configuration, such that the common emitter also comprises the base of a dual collector NPN load transistor, and each PNM base comprises an NPN collector. Circuit densities are approximately double the densities of comparable I²L configurations. Both speed and speed-power product are improved over conventional I²L (Fig. 2).

Croydon Printing Company Ltd.

Fig. 2

This invention relates to bipolar semiconductor logic circuits, and more particularly to the use of vertical Schottky collector (PNM) transistors in combination with one or more other components  to achieve high density, low power logic circuits, having improved speed compared to conventional $I^2L$.

Integrated injection logic requires high values of up beta and also down beta to achieve practical functionality. As a result, storage time delays are introduced which limit the performance of conventional $I^2L$ devices.

The vertical Schottky collector transistor has a low down beta due to the low minority carrier injection ratio of the Schottky barrier collector, which reduces storage delay and improves performance over conventional $I^2L$ and Schottky $I^2L$. PNM devices have been fabricated which demonstrate a 40% improvement in speed at five times lower current than advanced $I^2L$. For example, the Schottky collector devices have demonstrated speeds of 2.76 nanoseconds at 60 microamps versus 4.5 nanoseconds at 300 microamps for $I^2L$.

In an attempt to perform logic with the Schottky collector transistor switch using a DCTL configuration, the problem of current robbing due to low down beta is encountered. For example, the lower input impedance of the saturated transistor causes it to rob base drive from the other parallel transistor. A solution to the current robbing problem of DCTL was provided by inserting a ballast resistor in series with the base of each parallel transistor, which served to increase the effective input impedance of the saturated transistor thereby reducing its base current, and allowing the parallel device to receive an ample share of base drive. A similar solution exists for the Schottky collector device, which is implemented according to the invention in a very compact way simply by reducing the ohmic n+ dopant concentration of the base contact to provide a low barrier Schottky input, or to provide a non-linear resistor in series with the base, either of which would serve to increase input impedance of the saturated transistor and avoid current robbing.

Accordingly, it is an object of the present invention to introduce a new logic form, vertical Schottky logic (VSL), which has the potential to extend the range of high density, low power bipolar logic down to one nanosecond performance levels at five micrometer geometrics.

Broadly, the invention is embodied in a Schottky collector transistor inverter circuit; and is further embodied in a positive logic, multiple input, single output NAND gate implemented therewith; and is further embodied in a single input, multiple output NOR gate implemented therewith.

The Schottky collector transistor (PNM) inverter circuit comprises a PNM Schottky transistor merged with an NPN load transistor such that the PNM base also comprises the NPN collector; the PNM emitter also comprises the NPN base; and further includes a low barrier Schottky input diode or non-linear resistor in series with the merged PNM base/NPN collector.

The multiple-input single-output NAND function is achieved by merging two PNM inverters in a common emitter configuration, such that the common emitter also comprises the base of a dual collector NPN load transistor, and such that each PNM base comprises an NPN collector. The two PNM collectors are "wire ored".

The single-input multiple-output NOR function is achieved by coupling both inputs of a merged pair of PNM inverters; with each PNM collector providing a separate output.

Figure 1 is a circuit diagram of the Schottky collector transistor inverter circuit of the invention.

Figure 2 is an enlarged cross-sectional view of an integrated circuit device implementing the inverter circuit of Figure 1.

Figure 3 is a circuit diagram of the NAND function of the invention including the corresponding logic gate symbols.

Figure 4 is a logic gate representation of the NOR function of the invention.

Figure 5 shows the layout of two toggle D flip-flops in cascade implementing the divide by 4 function.

Figure 6 is a schematic diagram of the flip-flops shown in Figure 5.

In Figure 1 the inverter circuit of the invention is seen to include a Schottky collector transistor $T_1$ having a low barrier Schottky input diode or non-linear resistor input to the base region thereof. Load transistor $T_2$ is an NPN device, the base of which is common with the emitter of $T_1$; and the collector of which is common with the base of $T_1$.

As shown in Figure 2, the inverter of Figure 1 is integrated to include p-type region 21 constituting the emitter of $T_1$ merged with the base of $T_2$. N-type region 22 is the base of $T_1$ merged with the collector of $T_2$. The surface emitter contact 23 for the NPN device is laterally isolated from the remainder of the gate by oxide region 24, and is electrically connected to region 26 through subsurface n+ region 25. Contact 27 forms a low barrier height Schottky junction with n-type region 28, doped to a low resistivity by a light phosphorous implant (approximately $1.2 \times 10^{13}$ atoms per cc. at 35 KEV) through the oxide window prior to platinum silicide contact formation, whereby the same Schottky contact system, preferably platinum silicide, is then suitable for both the input diode and the Schottky collector 29.

In the alternative, increased doping of region 28 may be employed to further reduce the barrier heights of the Schottky contact, whereby the Schottky character of the contact becomes so degraded that a non-linear resistance is achieved instead of rectification. For example, a phosphorus ion implant dosage between $1.2 \times 10^{13}$ and $1 \times 10^{14}$ atoms per cc. prior to platinum silicide contact formation ensures a non-linear resistance.

The inverter is fabricated in an n-type epitaxial layer 26 over a selective n+ buried diffusion 25. A thick field oxide meets an up diffused boron channel stop implant to provide device isolation. A deep boron implant (energy = 700 KEV and dose = $1 \times 10^{14}$ atoms per centimeter$^2$) forms the intrinsic NPN base/PNM emitter, and a light phosphorous implant energy = 200 KEV and dose = $5 \times 10^{12}$ atoms per centimeter$^2$) determines the PNM intrinsic base properties. The NPN base/PNM emitter is reached by a P+ diffusion. Platinum silicide provides Schottky barrier contact to the n-type epitaxial region 22 above the ion implanted NPN intrinsic base; and also provides a Schottky contact having low barrier height to modified region 28. Platinum silicide is conveniently also useful to provide ohmic contact to the PNM emitter/NPN base and also to the NPN emitter.

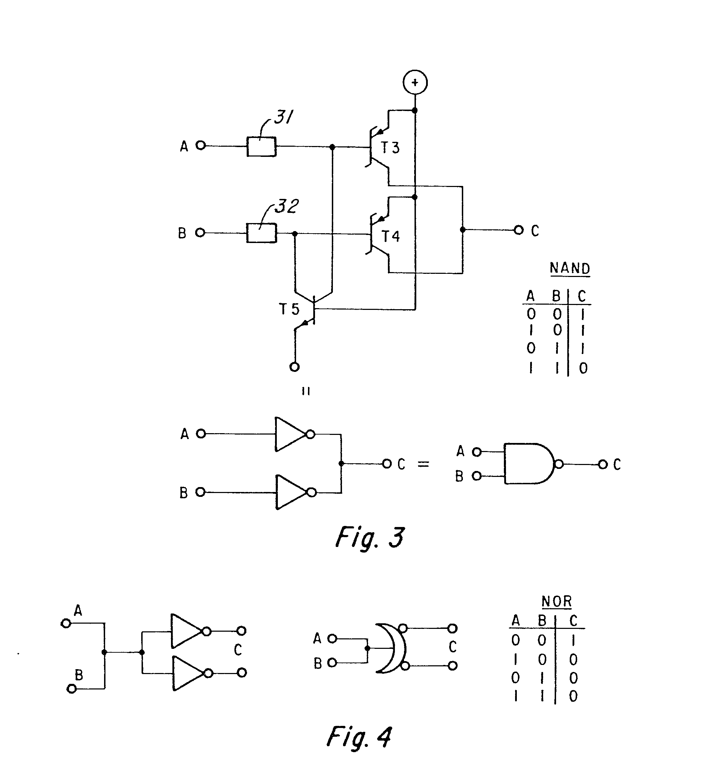

As seen in Figure 3, the NAND gate of the invention includes two Schottky collector transistors, $T_3$ and $T_4$ merged in a common emitter configuration such that their common emitter also comprises the base of a dual collector NPN load transistor $T_5$. Also, each PNM base comprises an NPN collector. Inputs A and B to the base of transistors $T_3$ and $T_4$, respectively, include low barrier Schottky diodes 31 and 32, which may in the alternative consist of non-linear resistors. The PNM collectors are interconnected to provide the single output C.

By reference to Figure 2 it can be seen that implementation of the NAND function is similar to implementation of the simple inverter circuit. That is, by providing a second n-type region like region 22, and including therein contacts like 27 and 29, the complete NAND function is achieved by interconnecting the two PNM collectors with surface metallization or equivalent interconnection.

Similarly, as in Figure 4, the NOR function is implemented by merging two parallel inverters as in Figure 3, and coupling both their inputs but not interconnecting the PNM collectors, so each collector is a separate output.

An "O" on either A or B of Figure 3 allows either $T_3$ or $T_4$ to turn on. As the outputs of $T_3$ and $T_4$ are "wire ored", C is pulled high to the "1" level. Therefore, a zero on an input provides a "1" on the output which is characteristic of NAND logic.

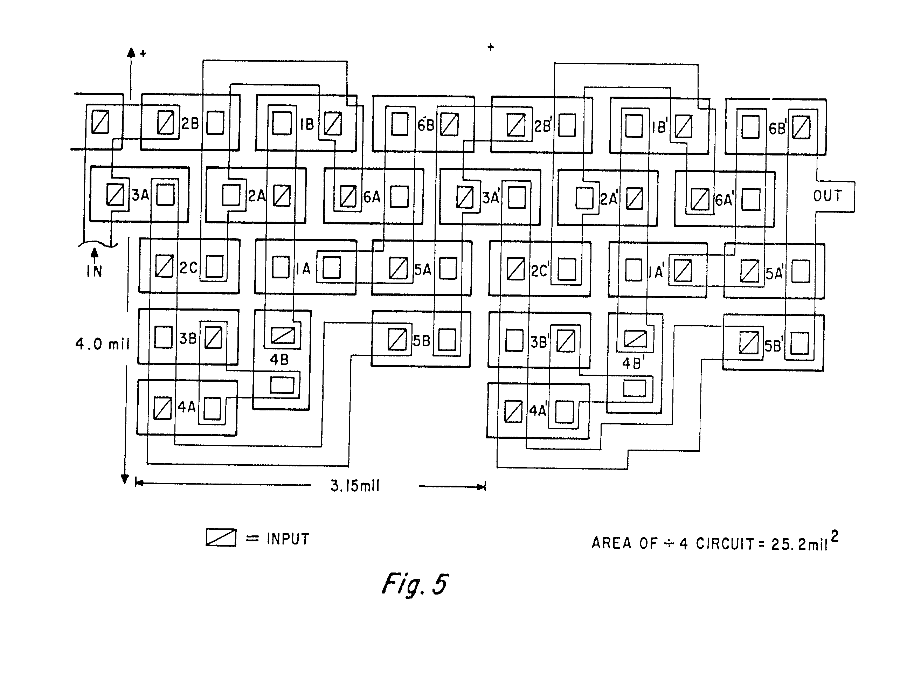

Similarly, a "1" on either A or B of Figure 4 turns both inverters off whose inputs are tied to them. "C" then goes low. A "one" on any input provides an "O" on the output which is characteristic of NOR logic. The layout of Figure 5 provides a divide by 4 function and requires only 12.6 mils$^2$

of surface area per flip-flop which is a density two times greater than a comparable layout using conventional $I^2L$ logic circuits. Supply current is carried in diffused layers thereby simplifying signal interconnects as in substrate fed logic (SFL).

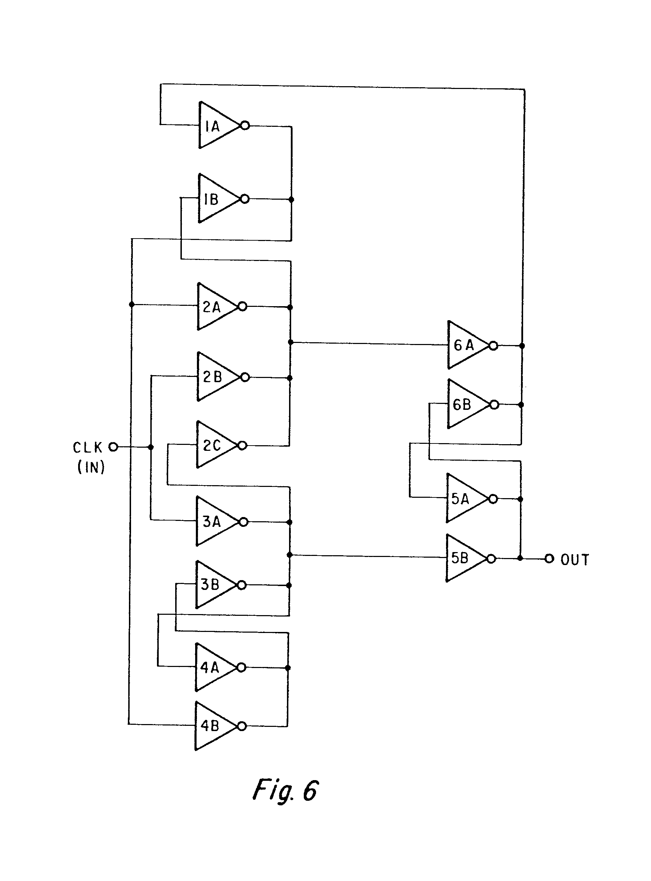

The flip-flops of Figure 5 are again illustrated schematically in Figure 6, wherein the gate numbering is the same as in Figure 5.

Claims

1. An inverter circuit comprising a Schottky collector transistor merged with an NPN load transistor such that the PNM base also comprises the NPN collector, and the PNM emitter also comprises the NPN base; and wherein the input to said PNM base includes a non-linear resistance.

2. A semiconductor circuit comprising two PNM inverters as in claim 1 merged in a common-emitter configuration such that the common emitter also comprises the base of a dual collector NPN load transistor, and such that each PNM base comprises an NPN collector; wherein the PNM collectors are coupled to provide a multiple-input single-output NAND function.

3. A semiconductor circuit including a pair of Schottky collector transistors merged in a common emitter configuration, both inputs of which are coupled to provide a single-input multiple-output NOR function.

4. A circuit as in claim 1, 2 or 3 wherein the input to each PNM base region comprises a PtSi contact to an n-type silicon surface doped by a phosphorus ion implant dosage between $1 \times 10^{12}$ and $1 \times 10^{14}$ atoms per cc.

5. A method for the fabrication of an integrated circuit, including a non-linear resistor, comprising the step of forming a PtSi contact to an n-type silicon surface doped by a phosphorus ion implant between $1 \times 10^{12}$ and $1 \times 10^{14}$ atoms per cc.

LOW BARRIER SCHOTTKY DIODE OR NON LINEAR RESISTOR

*Fig. I*

*Fig. 2*

NAND

| A | B | C |
|---|---|---|
| 0 | 0 | 1 |
| 1 | 0 | 1 |
| 0 | 1 | 1 |
| 1 | 1 | 0 |

**Fig. 3**

NOR

| A | B | C |
|---|---|---|
| 0 | 0 | 1 |
| 1 | 0 | 0 |
| 0 | 1 | 0 |
| 1 | 1 | 0 |

**Fig. 4**

*Fig. 5*

☑ = INPUT

AREA OF ÷ 4 CIRCUIT = 25.2 mil²

*Fig. 6*

0028354

European Patent
Office

EUROPEAN SEARCH REPORT

Application number

EP 80 10 6417

# DOCUMENTS CONSIDERED TO BE RELEVANT

| Category | Citation of document with indication, where appropriate, of relevant passages | Relevant to claim |
|---|---|---|
| X | FR - A - 2 353 960 (SIEMENS AKTIEN-GESELLSCHAFT)<br><br> * Figures 3,4; page 4, line 35 - page 6, line 33 * | 1 |
| P | & US - A - 4 183 036 | |
| | -- | |
| | IEEE JOURNAL OF SOLID-STATE CIR-CUITS, vol. SC-14, no. 5, October 1979, pages 801-806<br>New York, U.S.A.<br>F.W. HEWLETT: "A compact efficient Shottky collector transistor switch"<br><br> * Figures 3-9; pages 802-806: "The switching element" * | 1-5 |
| | -- | |
| | MICROELECTRONICS, vol. 7, no. 3, March 1976, pages 35-42<br>Luton<br>H.H. BERGER et al.: "Advanced merged transistor logic by using Schottky junctions"<br><br> * Figures 7-9a; page 38: "Schottky Transistor Logic (STL)" * | 1,2,4 |
| | -- | |
| | IEEE JOURNAL OF SOLID-STATE CIR-CUITS, vol. SC-10, no. 5, October 1975, pages 336-342<br>New York, U.S.A.<br>V. BLATT et al.: "Substrate fed logic"<br><br> * Whole article * | 1-4 |
| | -- | |
| | US - A - 4 104 732 (F.W. HEWLETT)<br>./. | 1-3 |

### CLASSIFICATION OF THE APPLICATION (Int Cl.)

H 01 L 27/02
H 03 K 19/091

### TECHNICAL FIELDS SEARCHED (Int Cl.)

H 01 L 27/02
H 03 K 19/091

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | |
|---|---|
| X | The present search report has been drawn up for all claims |

| Place of search | Date of completion of the search | Examiner |
|---|---|---|
| The Hague | 06-02-1981 | CARDON |

EPO Form 1503.1  06.78

## European Patent Office

## EUROPEAN SEARCH REPORT

| | DOCUMENTS CONSIDERED TO BE RELEVANT | | CLASSIFICATION OF THE APPLICATION (Int. Cl. 3) |
|---|---|---|---|
| Category | Citation of document with indication, where appropriate, of relevant passages | Relevant to claim | |
| | * Figures 1-3; column 1, line 54 - column 2, line 38 * ---- | | |

TECHNICAL FIELDS SEARCHED (Int. Cl. 3)

EPO Form 1503.2 06.78